# EUROPÄISCHE PATENTSCHRIFT

(11) **EP 1 332 247 B1**
(45) Veröffentlichungstag und Bekanntmachung des Hinweises auf die Patenterteilung: **29.09.2004**
(21) Anmeldenummer: 01960587.2
(22) Anmeldetag: 30.07.2001
(51) Int. Cl.: C30B 33/00, B28D 5/00

(54) **VERFAHREN UND VORRICHTUNG ZUM TRENNEN VON EINKRISTALLEN, SOWIE EINE JUSTIERVORRICHTUNG UND EIN TESTVERFAHREN ZUM ERMITTELN EINER KRISTALLORIENTIERUNG**
METHOD AND DEVICE FOR CUTTING SINGLE CRYSTALS, IN ADDITION TO AN ADJUSTING DEVICE AND A TEST METHOD FOR DETERMINING A CRYSTAL ORIENTATION
PROCEDE ET DISPOSITIF POUR LE DECOUPAGE DE MONOCRISTAUX, DISPOSITIF D'AJUSTAGE ET PROCEDE DE TEST POUR DETERMINER UNE ORIENTATION CRISTALLINE

(30) Priorität: 20.10.2000 DE 10052154
(43) Veröffentlichungstag der Anmeldung: 06.08.2003
(73) Patentinhaber: Freiberger Compound Materials GmbH, 09599 Freiberg (DE)
(72) Erfinder: HAMMER, Ralf, 09599 Freiberg (DE); KLEINWECHTER, André, 09599 Freiberg (DE); FLADE, Tilo, 09599 Freiberg (DE); KUMANN, Cornelia, 09600 Oberschöna (DE); GRUSZYNSKY, Ralf, 09618 Brand-Erbisdorf (DE)
(74) Vertreter: Hofer, Dorothea, Dipl.-Phys.
(86) Internationale Anmeldenummer: PCT/EP2001/008800
(87) Internationale Veröffentlichungsnummer: WO 2002/034973

(56) Entgegenhaltungen:
- EP-A- 0 269 997
- CH-A- 690 422
- DE-A- 3 826 698
- GB-A- 628 508
- US-A- 5 839 424
- US-A- 5 878 737
- US-A- 5 904 136
- PATENT ABSTRACTS OF JAPAN vol. 1999, no. 08, 30. Juni 1999 (1999-06-30) & JP 11 074234 A (SUPER SILICON KENKYUSHO:KK), 16. März 1999 (1999-03-16)
- PATENT ABSTRACTS OF JAPAN vol. 1997, no. 05, 30. Mai 1997 (1997-05-30) & JP 09 017755 A (SUMITOMO ELECTRIC IND LTD), 17. Januar 1997 (1997-01-17)

## Beschreibung

Die Erfindung betrifft ein Verfahren und eine Vorrichtung zum Trennen von Einkristallen, eine Justiervorrichtung und ein Testverfahren zum Ermitteln einer Orientierung eines Einkristalls für ein derartiges Verfahren.

Zur Anwendung in der Halbleitertechnologie werden durch Kristallzüchten erzeugte Einkristalle in einzelne Scheiben, die als Wafer bezeichnet werden, getrennt. Bekannte Trennverfahren sind das Innenlochsägen und das Drahtsägen. Die beim Trennen der Einkristalle auftretenden Schnittkräfte führen zu einer seitlichen Auslenkung der Trennscheibe im Fall des Innenlochsägens bzw. des Drahtes im Fall des Drahtsägens. Dadurch wird eine ungleichmäßige Dicke des Wafers erzeugt oder die Oberfläche weist andere Ungleichmäßigkeiten z.B. Warp und Bow auf. Bei Siliziumeinkristallen tritt vor allen Dingen das Problem der Welligkeit der Oberfläche auf. Dies führt zu einer verminderten Qualität der erzeugten Wafer und somit zu einer geringeren Ausbeute an hochqualitativen Wafern.

Zur Lösung dieses Problemes ist es bekannt, beim Innenlochsägen die Auslenkung der Trennscheibe zu messen und durch Einwirkung von Druckluft zu korrigieren. Dieses Verfahren weist aber den Nachteil auf, daß ein zum Kühlen der Trennscheibe aufgebrachter Kühlmittelfilm durch die Druckluft beeinflußt wird, was sich wiederum auf die Kühlung beim Trennen auswirkt. Ferner ist es bekannt, den Einkristall in eine Halterung zu setzen, die speziell geformt ist, um den bei der Auslenkung der Trennscheibe auftretenden Kräften entsprechende Gegenkräfte zur Kompensation entgegen zu setzen. Beim Drahtsägen ist keine aktive Beeinflussung der Auslenkung des Drahtes möglich.

Es ist Aufgabe der Erfindung, ein Verfahren und eine Vorrichtung zum Trennen von Einkristallen, eine Justiervorrichtung und ein Testverfahren zum Ermitteln einer Orientierung eines Einkristalls für ein derartiges Verfahren bereit zu stellen, mit dem bzw. mit der die oben genannten Probleme vermieden werden.

Die Aufgabe wird gelöst durch ein Verfahren nach Patentanspruch 1, eine Vorrichtung nach Patentanspruch 8, eine Vorrichtung zum Justieren nach Patentanspruch 12 und ein Testverfahren nach Patentanspruch 16.

Weiterbildungen der Erfindung sind in den Unteransprüchen angegeben.

Das Verfahren und die Vorrichtung haben den Vorteil, daß die Qualität der Wafer erhöht wird und daß beim Trennen höhere Vorschubgeschwindigkeiten ermöglicht werden. Dadurch läßt sich insbesondere für GaAs das Innenlochsägen auch für Wafer von 6 Zoll Durchmesser und ggf. größer anwenden. Durch die verbesserte Qualität der erzeugten Wafer können sonst übliche Nachbearbeitungsschritte weitgehend entfallen.

Weitere Merkmale und Zweckmäßigkeiten der Erfindung ergeben sich aus der Beschreibung von Ausführungsbeispielen anhand der Figuren.

Von den Figuren zeigen:
- Fig. 1: eine schematische Darstellung in der Draufsicht in Richtung der Mittenlängsachse des Einkristalls einer Vorrichtung zum Innenlochsägen;
- Fig. 2: eine schematische Seitenansicht einer Vorrichtung zum Innenlochsägen gemäß einer Ausführungsform der Erfindung;
- Fig. 3: eine schematische Darstellung einer Vorrichtung zum Drahtsägen aus perspektivischer Sicht;
- Fig. 4: eine schematische Darstellung einer Vorrichtung zum Drahtsägen entsprechend einer Ausführungsform der Erfindung in Seitenansicht;
- Fig. 5: eine schematische Darstellung in Seitenansicht eines Wafers beim Innenlochsägen;
- Fig. 6: eine Darstellung der beim Innenlochsägen auftretenden Kräfte;
- Fig. 7: eine Darstellung kritischer Eindringtiefen für die Vernetzung von Mikrorissen in Abhängigkeit von einer Vorschubrichtung eines Trennwerkzeuges beim Trennen eines GaAs Einkristalls;
- Fig. 8: eine Darstellung der Extremwerte der resultierenden Kraft der axialen Zwangskraftkomponenten, die zur Querauslenkung eines Trennwerkzeuges führt, in Abhängigkeit von der Vorschubrichtung des Trennwerkzeuges beim Trennen eines GaAs Einkristalls mittels Innenlochsägen;
- Fig. 9: eine Darstellung des Warps des Wafers in Abhängigkeit von der Einstellung einer bestimmten Kristallrichtung zu einer Vorschubrichtung des Trennwerkzeuges am Beispiel von GaAs mittels Innenlochsägen;
- Fig. 10: eine Darstellung der Rauhigkeit des Wafers in Abhängigkeit von der Einstellung der bestimmten Kristallrichtung zu einer Vorschubrichtung des Trennwerkzeuges am Beispiel von GaAs;
- Fig. 11: eine schematische Darstellung eines Schrittes des erfindungsgemäßen Testverfahrens zum Ermitteln des optimalen Winkels der bestimmten Kristallrichtung zur Vorschubrichtung des Trennwerkzeuges für das Drahtsägen;
- Fig. 12: eine schematische perspektivische Darstellung der Vorrichtung zum Justieren des Einkristalls.

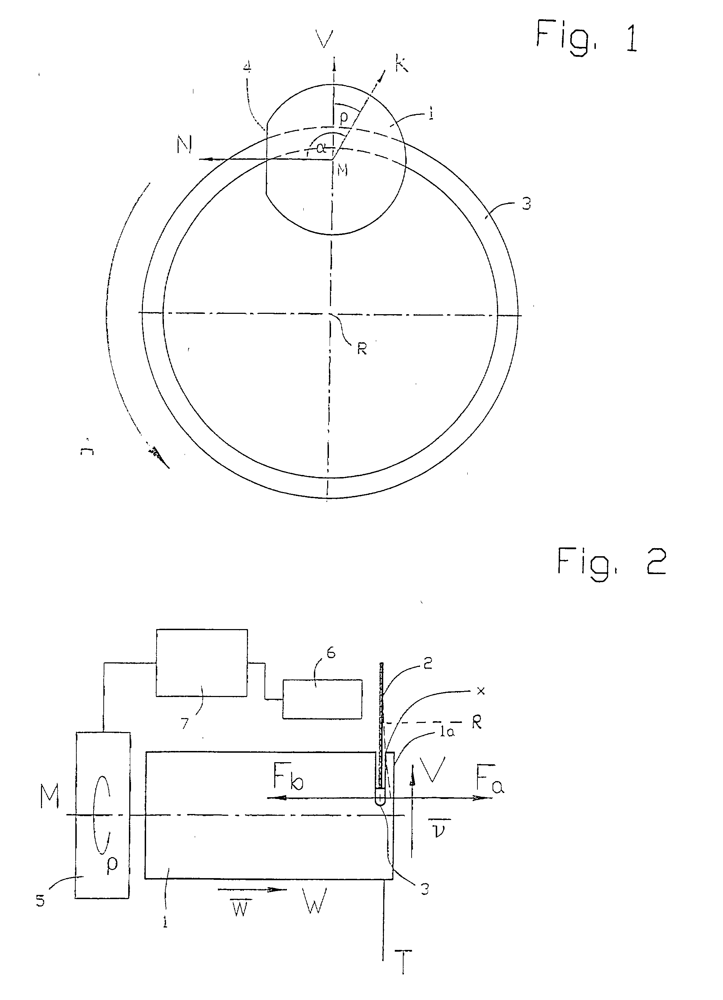

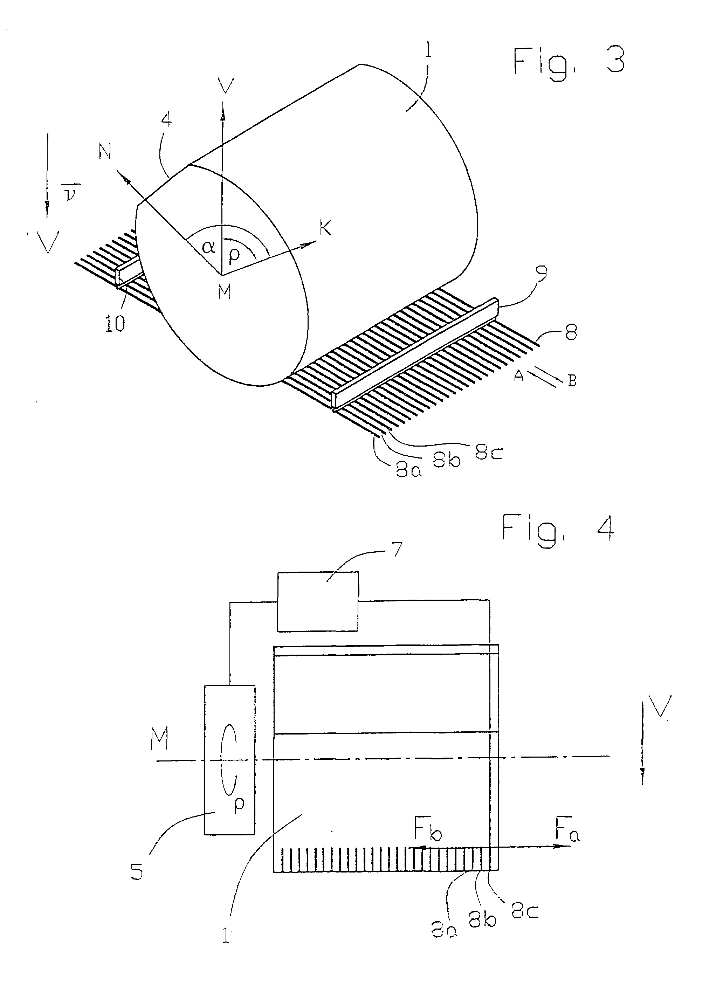

Wie aus den Figuren 1 und 2 ersichtlich ist, weist eine erfindungsgemäße Vorrichtung gemäß einer ersten Ausführungsform der Erfindung eine Innenlochsägevorrichtung auf. Ein Einkristall 1 vom im wesentlichen zylindrischer Form mit einer Mittenlängsachse M ist von einer nicht dargestellten Halterung gehalten. Eine Innenlochtrennscheibe 2, die in bekannter Weise aus einer Metallscheibe mit einem konzentrischen Loch besteht, an dessen Begrenzung durch Aufbringen von Diamantkörnern eine Schneidkante 3 gebildet ist, ist um eine Rotationsachse R relativ zu dem Einkristall derart drehbar gelagert, daß die Mittenlängsachse M des Einkristalls und die Rotationsachse R der Trennscheibe parallel zueinander verlaufen. Es ist ein nicht dargestellter Antrieb vorgesehen, mit der die Trennscheibe 2 mit einer definierten Geschwindigkeit um die Rotationsachse R in der in Fig. 1 dargestellten Richtung A drehbar ist. Der Einkristall 1 ist über einen Antrieb einer Vorschubeinheit in der in Fig. 2 dargestellten Vorschubrichtung V in Richtung auf die Trennscheibe 2 derart bewegbar, daß die Trennscheibe 2 den Einkristall 1 vollständig in einer Ebene senkrecht zu seiner Mittenlängsachse M durchtrennen kann. Ferner ist ein Antrieb vorgesehen zum Bewegen des Einkristalls 1 senkrecht zur Trennscheibe 2 bzw. entlang der Richtung seiner Mittenlängsachse mit einer Geschwindigkeit w.

Wie insbesondere aus Fig. 1 ersichtlich ist, ist der Einkristall 1 nicht ganz zylinderförmig, sondern weist einen ebenen Außenflächenabschnitt 4 auf, den sogenannten Flat, der derart nach dem Züchten des Einkristalls 1 in definierter Weise angebracht worden ist, daß ein Winkel α, den eine bestimmte kristallographische Richtung K, für GaAs beispielsweise eine [011]-Richtung, mit der Normalen N auf den ebenen Außenflächenabschnitt 4, in einer Ebene senkrecht zur Mittenlängsachse M einschließt, bekannt ist. Da der Winkel α bekannt ist, ist somit auch ein Winkel ρ zwischen der bestimmten kristallographischen Richtung K und der Vorschubrichtung V des Einkristalls in einer Ebene senkrecht zur Mittenlängsachse M des Einkristalls und somit in der Trennebene T bekannt. Es ist anzumerken, daß anstelle des Flats auch ein Notch genannter Einschnitt an der Außenseite des Einkristalls vorgesehen sein kann. Entscheidend ist lediglich ein äußeres Merkmal, dessen Anordnung zur bestimmten kristallographischen Richtung bekannt ist.

Wie in Fig. 2 gezeigt ist, weist die Vorrichtung ferner an dem der Trennscheibe 2 abgewandten Ende des Einkristalls 1 eine Einrichtung 5 zum Drehen des Einkristalls 1 um seine Mittenlängsachse M auf. Ferner ist ein Sensor 6 vorgesehen zum Messen einer Auslenkung X der Trennscheibe 2 aus der Trennebene T heraus beim Trennen eines scheibenförmigen Abschnitts 1a von dem Einkristall 1, der den späteren Wafer bildet. Der Sensor 6 und die Einrichtung 5 zum Drehen des Einkristalls 1 sind über eine Regeleinrichtung 7 miteinander verbunden, die derart ausgebildet ist, daß in Abhängigkeit von der gemessenen Auslenkung X der Trennscheibe 2 die Dreheinrichtung 5 betätigt wird, so daß der Einkristall 1 in eine vorgegebenen azimutale Position gedreht wird, so daß die bestimmte kristallographische Richtung K mit der Vorschubrichtung V einen der gemessenen Auslenkung X der Trennscheibe 2 entsprechenden vordefinierten Winkel ρ einnimmt.

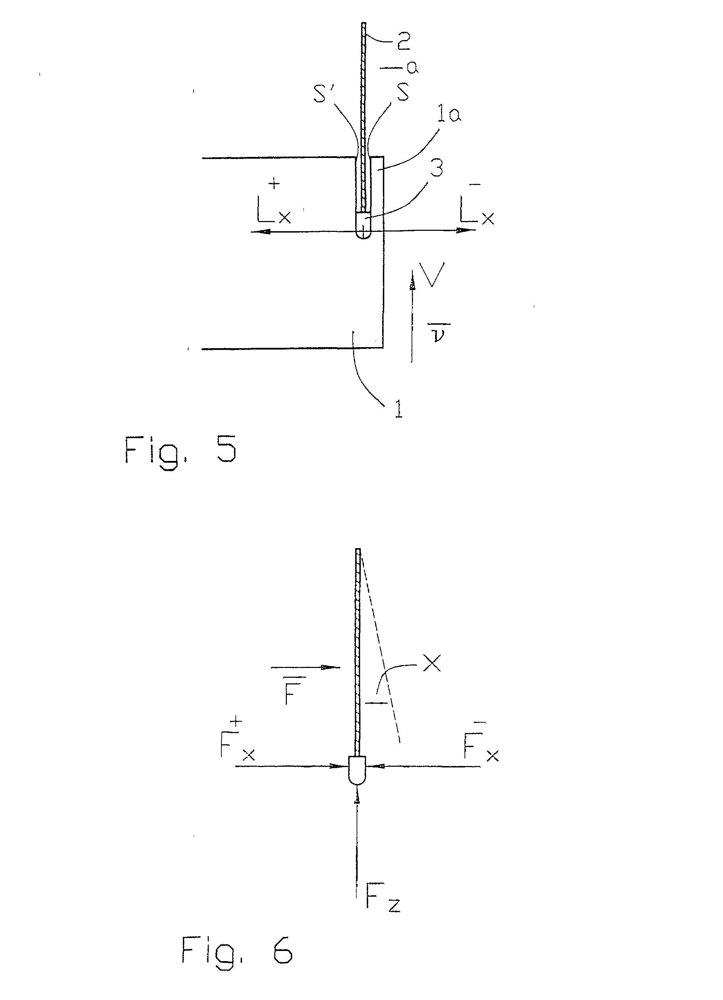

In einer abgewandelten Ausführungsform ist die Vorrichtung zum Trennen eines Einkristalls eine Drahtsägevorrichtung, wie in den Figuren 3 und 4 gezeigt ist. Der in den Figuren 1 und 2 gezeigten Vorrichtung entsprechende Teile sind mit den gleichen Bezugszeichen versehen. Wie in Fig. 3 gezeigt ist, ist der Einkristall 1 in einer nicht dargestellten Halterung gehalten, die über einen Antrieb einer Vorschubeinheit auf das Drahtfeld einer Drahtsäge 8 hin und wieder zurück bewegbar ist. Die Drahtsäge 8 besteht aus einer Vielzahl von parallel verlaufenden Drähten 8a, 8b, 8c, die über nicht dargestellte Rollen gespannt sind und in Ebenen senkrecht zur Mittenlängsachse M des Einkristalls 1 in den durch Pfeile gezeigten Richtungen A und B bewegbar sind. Die Vorrichtung umfaßt ferner eine Vorrichtung 9 zum Aufbringen einer Paste, welche Diamantkörner enthält, auf die Drähte 8a, 8b, 8c auf einer Seite des Einkristalls 1 und eine Vorrichtung 10 zum Reinigen der Drähte nach Durchtritt durch den Einkristall und zum Austragen des Abtrages beim Durchgang der Drähte durch den Einkristall. Alternativ ist das Diamantkorn bereits fest in den Draht eingebunden und ein Aufbringen mittels einer Paste ist nicht erforderlich. Analog zu der in Fig. 2 dargestellten Vorrichtung weist diese Ausführungsform, wie in Fig. 4 dargestellt ist, ebenfalls eine Einrichtung 5 zum Drehen des Einkristalls 1 und einen Sensor, der die Auslenkung eines Drahtes 8a, 8b bzw. 8c erfaßt, und eine Regeleinrichtung 7 zum Steuern der Einrichtung 5 zum Drehen des Einkristalls 1 in Abhängigkeit von der erfaßten Drahtauslenkung auf.

Der Betrieb der Vorrichtung gemäß den Figuren 1 und 2 wird nun im folgenden im Zusammenhang mit den Figuren 5 bis 10 beschrieben.

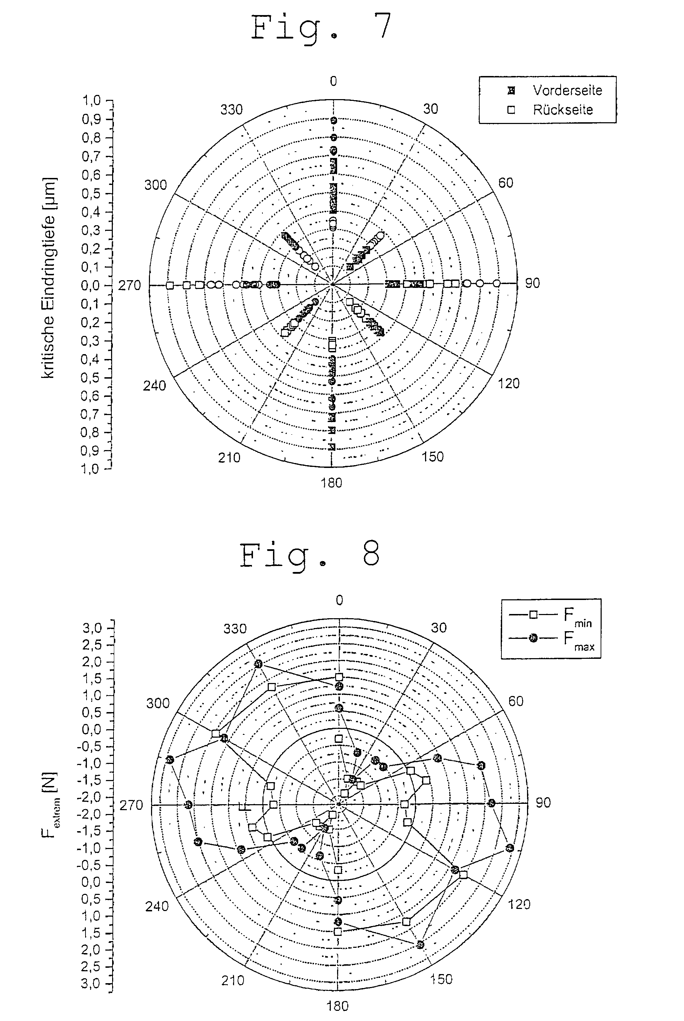

Nach der Montage des Einkristalls 1 in der Halterung wird die Halterung in der in Fig. 2 gezeigten Richtung W über den Antrieb derart vorgeschoben, daß zwischen dem freien Ende 1a des Einkristalls und der Trennscheibe 2 ein Abstand a verbleibt, der etwas mehr als die Dicke eines zu erzeugenden Wafers beträgt. Dann wird der Einkristall 1 über den Antrieb in der in den Figuren 2 und 5 dargestellten Vorschubrichtung V mit einer Vorschubgeschwindigkeit v gegen die Trennscheibe 2 bewegt, welche ihrerseits um ihre Rotationsachse in der in Fig. 1 dargestellten Richtung A rotiert. Die rotierende Trennscheibe 2 greift in den Einkristall 1 ein zum Abtrennen eines Abschnittes 1a, der den späteren Wafer bildet, von dem Einkristall 1. Die Diamantkörner der Schneidkante 3 der Trennscheibe 2 erzeugen beim Trennvorgang nach dem Erreichen einer kritischen Eindringtiefe in den Einkristall 1 Mikrorisse, die durch gegenseite Vernetzung zum Materialabtrag führen. Diese kritische Eindringtiefe hängt von der Bewegungsrichtung des Korns zur bestimmten kristallographischen Richtung K ab. Makroskopisch gesehen hängt die kritische Eindringtiefe von dem Winkel p, den die bestimmte kristallographische Richtung K mit der Vorschubrichtung V in einer Ebene senkrecht zur Mittenlängsachse M des Einkristalls einschließt, ab. Es wurde herausgefunden, daß die kritische Eindringtiefe auf jeweils gegenüberliegenden Seiten S, S' der eingreifenden Trennscheibe 2 liegen, unterschiedlich ist. Fig. 7 zeigt die kritische Eindringtiefe auf der in Fig. 5 dargestellten, der Trennscheibe 2 gegenüberliegenden Vorderseite S und der Rückseite S' für verschiedene Winkeleinstellungen p der bestimmten kristallographischen Richtung K zur Vorschubrichtung V. Diese unterschiedliche Eindringtiefe auf Vorderseite S und Rückseite S' relativ zu der Trennscheibe 2 führt zu unterschiedlichen kritischen Lasten Lₓ⁻ für die Vorderseite S und Lₓ⁺ für die Rückseite S'. Somit erfährt die Schneidkante 3 unterschiedliche Zwangskräfte Fₓ⁻, Fₓ⁺ von Vorderseite S und Rückseite S', zusätzlich zu der in Vorschubrichtung V wirkenden Zwangskraft Fz beim Auftreffen auf das Material des Einkristalls 1, wie in Fig. 6 gezeigt ist. Diese unterschiedlich großen richtungsabhängigen Zwangskräfte Fₓ⁻, Fₓ⁺ führen zu einer resultierenden Kraft F, die zu einer richtungsabhängigen Querauslenkung X führt.

Wie in Fig. 8 dargestellt ist, ist die resultierende Kraft F, die aus der Summe der Zwangskräfte Fₓ⁻, Fₓ⁺ und Fz entsteht, abhängig von der Vorschubrichtung V relativ zu der bestimmten kristallographischen Richtung K, d.h. dem Winkel ρ, den diese beiden Richtungen miteinander in der Trennebene senkrecht zur Mittenlängsachse des Einkristalls 1 einschließen. In Abhängigkeit von dem Material des Einkristalls, bzw. bei Halbleitern auch von der Dotierung, und von anderen Faktoren gibt es bevorzugte Winkel, bei denen sich die o.g. Zwangskräfte kompensieren und die Trennscheibe 2 ohne Querauslenkung in den Einkristall 1 eindringt.

Bei dem erfindungsgemäßen Verfahren werden die o.g. Zwangskräfte zur Korrektur der Querauslenkung X der Trennscheibe während des Schnittes genutzt. Hierzu wird, wie in Fig. 2 dargestellt ist, die Auslenkung X der Trennscheibe oder die axiale Schnittkraftkomponente Fₐ bzw. F_{b} mittels des Sensors 6 gemessen. In Abhängigkeit von dem gemessenen Wert wird die Einrichtung 5 zum Drehen des Einkristalls 1 über die Regeleinrichtung 7 derart betätigt, daß der Winkel p zwischen der bestimmten kristallographischen Richtung K und der Vorschubrichtung V so eingestellt wird, daß die Querauslenkung mittels der Zwangskräfte Fₓ⁻, Fₓ⁺ auf im wesentlichen Null geregelt wird. In bestimmten Fällen ist es auch von Vorteil, die Trennscheibe bzw. das Trennwerkzeug in definierter Weise leicht auszulenken. Dies erfolgt ebenso durch Einstellen des Winkels p.

Das Verfahren ist für die in den Fig. 3 und 4 gezeigte Drahtschneidevorrichtung genauso anwendbar, wobei dabei dann die Auslenkung eines oder mehrerer Drähte gemessen wird.

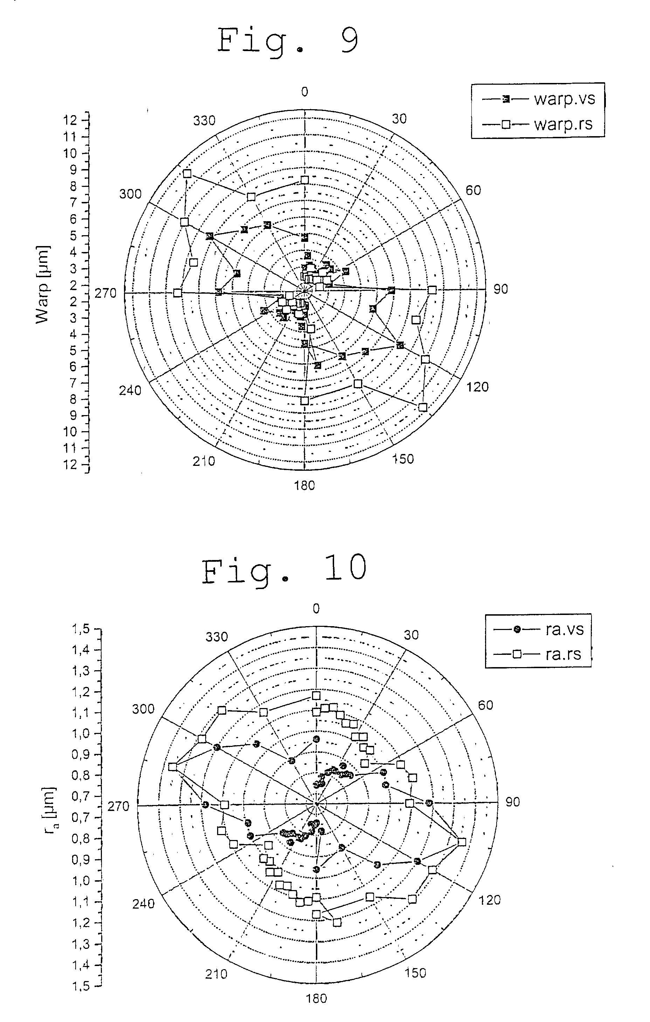

Im Ergebnis erhält man, wie in den Fig. 9 und 10 gezeigt ist, mit Hilfe der Nutzung der Zwangskräfte für die aktive Beeinflussung der Querauslenkung eine Korrektur des Warps und der Rauhigkeit ra durch Drehen des Einkristalls um seine Mittenlängsachse M zur Einstellung eines bestimmten Winkels p zwischen der bestimmten kristallographischen Richtung K und der Vorschubrichtung V.

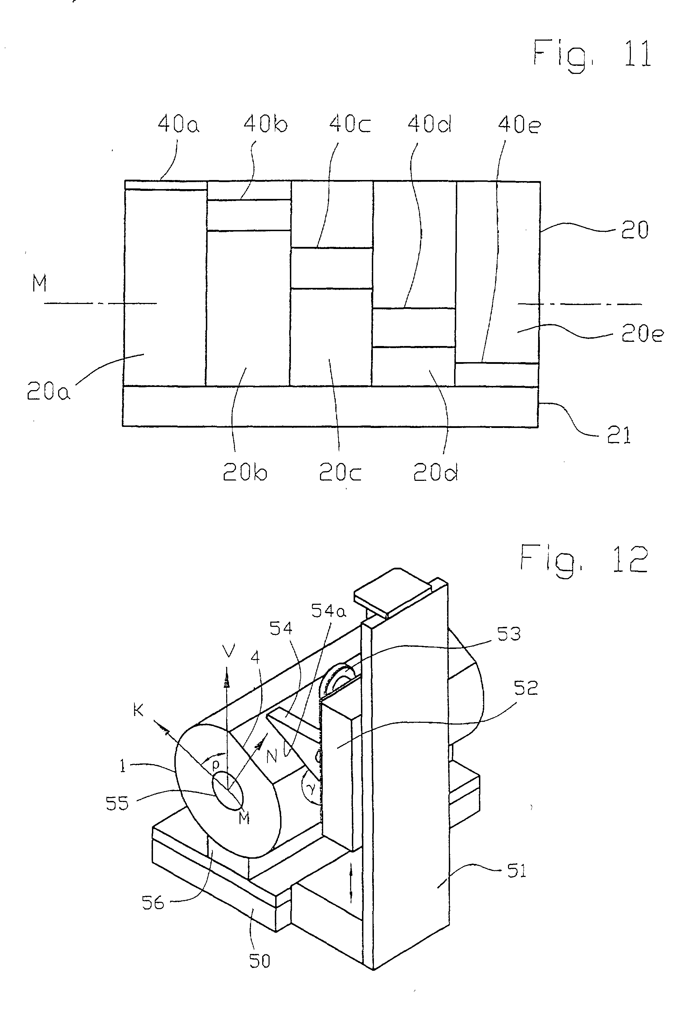

Die bevorzugten Winkel der bestimmten kristallographischen Richtung K zur Vorschubrichtung V, bei denen die Auslenkung des Trennwerkzeugs beim Schnitt zu Null wird, sind von dem Material des Einkristalls abhängig. Diese Winkel werden für jedes Material eines Einkristalls empirisch mittels eines Testverfahrens ermittelt. Dabei wird, wie in Fig. 11 dargestellt ist, ein Einkristall 20 eines bestimmten Materials in eine Mehrzahl von Scheiben 20a bis 20e getrennt, deren Dicke einer Mehrzahl von Dicken der später herzustellenden Wafer entspricht. Die Scheiben werden anschließend auf eine Halterung 21 derart aufgeklebt, daß ihre ebenen Außenflächenabschnitte (Flats) 40a bis 40e z.B. in einer Drahtsägevorrichtung in jeweils unterschiedlichen Winkeln zur Vorschubrichtung V angeordnet sind. Anschließend wird der so aus den Scheiben 20a bis 20e zusammengesetzte Einkristall 20 in der Trennvorrichtung gleichzeitig in einzelne Wafer getrennt und die Waferoberflächen der so erhaltenen Wafer auf Rauhigkeit und Warp vermessen. Das Verfahren wird so oft wiederholt, bis die bevorzugten Winkel für optimales Trennen ermittelt worden sind. Die so ermittelten Winkel dienen als Startgröße für den Trennvorgang später zu trennender Einkristalle in den in den Fig. 1 bis 4 gezeigten Vorrichtungen, wobei die Nachregelung der Einstellung des Winkels über die Einrichtung 5 und die Regeleinrichtung 7 zur Korrektur während des Trennvorganges dienen.

Zum Einsetzen des Einkristalles 1 unter einem vorgegebenen Winkel p zwischen der bestimmten kristallographischen Richtung K und der Vorschubrichtung V in die in den Fig. 1 bis 4 gezeigten Vorrichtungen ist die in Fig. 12 dargestellte Justiervorrichtung vorgesehen. Die Justiervorrichtung weist eine Basisplatte 50 und einen sich von dieser vertikal nach oben erstreckenden Träger 51 auf. Auf dem Träger 51 ist ein Reiter 52 vorgesehen, der beispielsweise auf einer nicht dargestellten Schiene in vertikaler Richtung auf und ab verschiebbar ist und mittels einer Befestigungsvorrichtung 53 in einer vorbestimmten Höhe arretierbar ist. Der Reiter 52 weist einen Ansatz 54 in Form eines Winkels auf, dessen Unterkante 54a mit der Vertikalen einen vorbestimmten Winkel γ einschließt. Beim Justieren wird der Einkristall 1, der mit einem Verbindungsstück 55 zum Einsetzen des Einkristalls in eine der in den Fig. 1 bis 4 gezeigten Trennvorrichtung fest verbunden ist, auf eine Leiste 56, beispielsweise aus Graphit, aufgeklebt, wobei der verwendete Klebstoff ein Klebstoff ist, der erst nach einer vorbestimmten Zeit aushärtet, so daß der Einkristall 1 auf der Leiste 56 noch für eine gewisse Zeit um seine Mittenlängsachse M drehbar ist. Der Einkristall 1 wird sodann samt dem Verbindungsstück 55 und der Leiste 56 in die Justiervorrichtung eingebracht, wobei der Reiter 52 zuvor auf der für diesen Einkristalltyp erforderlichen Höhe fixiert ist. Durch Schieben des Einkristalls 1 mitsamt dem Verbindungsstück 55 und der Leiste 56 unter den Winkel 54 wird der Einkristall 1 so justiert, daß sein ebener Außenflächenabschnitt 4 an der Unterkante 54a des winkelförmigen Ansatzes 54 anliegt. Der Winkel γ, den die Unterkante 54a des Ansatzes 54 mit der Vertikalen bildet, ist dabei derart gewählt, daß für diesen spezifischen Einkristall 1 ein bestimmter bevorzugter Winkel p zwischen der bestimmten kristallographischen Richtung K zu der Vertikalen eingestellt wird. Nachdem der Einkristall 1 fest auf der Leiste 56 angekettet ist, wird er in die Vorrichtung zum Trennen eingesetzt. Die Vorschubrichtung V stimmt mit der Vertikalen überein, so daß der Winkel ρ definiert ist.

Die oben beschriebene Erfindung weist den besonderen Vorteil auf, daß damit insbesondere GaAs Wafer mit einem Durchmesser von 6 Zoll oder ggf. mehr noch problemlos mit dem Innenlochsägen getrennt werden können, weil eine erhöhte Vorschubgeschwindigkeit möglich ist.

Die Erfindung ist nicht auf das Trennen von Halbleitereinkristallen (reinen Elementen, Halbleitern, halbleitenden Verbindungen) beschränkt. Das erfindungsgemäße Verfahren und die Vorrichtung können vielmehr auch zum Trennen beliebiger Einkristalle, wie optischen Einkristallen oder Keramik eingesetzt werden.

## Patentansprüche

1. Verfahren zum Trennen von einkristallinen Werkstoffen, wobei ein in wenigstens zwei Teile zu trennender Einkristall (1) und ein Trennwerkzeuge (2, 3; 8, 8a, 8b, 8c) relativ zueinander in einer Vorschubrichtung (V) bewegt werden, und wobei der Einkristall (1) derart orientiert ist, daß eine bestimmte kristallographische Richtung (K) in der Trennebene (T) liegt, **dadurch gekennzeichnet, daß** ein Winkel (ρ) zwischen der bestimmten kristallographischen Richtung (K) und der Vorschubrichtung (V) derart gewählt wird, daß Kräfte, die beim Trennen auf das Trennwerkzeug in einer Richtung senkrecht zur Trennebene (T) wirken einander kompensieren oder sich zu einer vorbestimmten Kraft summieren.

2. Verfahren nach Anspruch 1, **dadurch gekennzeichnet, daß** eine Auslenkung (X) des Trennwerkzeugs (2, 3; 8, 8a, 8b, 8c) beim Trennen gemessen wird und der Einkristall (1) in Abhängigkeit von dem gemessenen Wert mit der bestimmten kristallographischen Richtung (K) in der Trennebene (T) gedreht wird.

3. Verfahren nach Anspruch 1 oder 2, **dadurch gekennzeichnet, daß** das Trennen mittels Innenlochsägen erfolgt.

4. Verfahren nach Anspruch 1 oder 2, **dadurch gekennzeichnet, daß** das Trennen mittels Drahtsägen erfolgt.

5. Verfahren nach einem der Ansprüche 1 bis 4, **dadurch gekennzeichnet, daß** der Winkel (ρ) vor dem Trennen empirisch ermittelt wird.

6. Verfahren nach einem der Ansprüche 1 bis 5, **dadurch gekennzeichnet, daß** das Einstellen des Winkels (p) über eine Justiervorrichtung außerhalb der eigentlichen Trennvorrichtung erfolgt.

7. Verfahren nach einem der Ansprüche 1 bis 6, **dadurch gekennzeichnet, daß** das Verfahren zum Trennen von Einkristallen (1) der III-V Halbleiter, insbesondere GaAs verwendet wird.

8. Vorrichtung zum Trennen von Einkristallen mit einem Trennwerkzeug (2, 3; 8, 8a, 8b, 8c),
einer Halterung für den Einkristall (1),
einem Antrieb zum Bewegen der Halterung und des Trennwerkzeugs relativ zueinander in einer Vorschubrichtung (V), die senkrecht zur Mittenlängsachse (M) des Einkristalls (1) verläuft, und
einer Dreheinrichtung (5) zum Drehen der Halterung, mit der die Halterung derart drehbar ist, daß der Einkristall (1) um seine Mittenlängsachse (M) gedreht werden kann, **gekennzeichnet durch** eine Meßeinrichtung (6) zur Messung einer Auslenkung (X) des Trennwerkzeugs in einer Richtung senkrecht zur Vorschubrichtung (V).

9. Vorrichtung nach Anspruch 8, **gekennzeichnet durch** eine Regeleinrichtung, die mit der Meßeinrichtung (6) und der Dreheinrichtung (5) verbunden ist und die Dreheinrichtung (5) derart steuert, daß der Einkristall so gedreht wird, daß die Auslenkung des Trennwerkzeugs im wesentlichen 0 ist oder einen vorbestimmten Wert erreicht.

10. Vorrichtung nach Anspruch 8 oder 9, **dadurch gekennzeichnet, daß** die Vorrichtung eine Innenlochsägevorrichtung ist.

11. Vorrichtung nach Anspruch 8 oder 9, **dadurch gekennzeichnet, daß** die Vorrichtung eine Drahtsägevorrichtung ist.

12. Vorrichtung zum Justieren eines Einkristalls, wobei der Einkristall (1) im wesentlichen zylinderförmig mit einer Mittenlängsachse (M) ausgebildet ist und wobei der Einkristall einen ebenen Außenflächenabschnitt (4) aufweist und eine bestimmte kristallographische Richtung (K) des Einkristalls einen bekannten Winkel (α) zu der Normalen (N) auf den ebenen Außenflächenabschnitt in einer Ebene senkrecht zur Mittenlängsachse (M) aufweist, mit
einem auf einem vertikal ausgerichteten Träger (51) vorgesehenen Anschlag mit einer Unterkante (54), die mit der Vertikalen einen vorbestimmten Winkel (γ) einschließt.

13. Vorrichtung nach Anspruch 12, **dadurch gekennzeichnet, daß** der Anschlag höhenverstellbar ist.

14. Vorrichtung nach Anspruch 12 oder 13, **dadurch gekennzeichnet, daß** verschiedene auswechselbare Anschläge mit unterschiedlichen Winkeln (γ) vorgesehen sind.

15. Vorrichtung nach einem der Ansprüche 12 bis 14, **dadurch gekennzeichnet, daß** die Vorrichtung eine Justiervorrichtung für die Durchführung des Verfahrens nach einem der Ansprüche 1 bis 8 ist.

16. Testverfahren zum Ermitteln des optimalen Winkels zwischen der bestimmten kristallographischen Richtung (K) und der Vorschubrichtung (V) des Verfahrens nach einem der Ansprüche 1 bis 8 mit den Schritten
Trennen eines Einkristalls, wobei der Einkristall im wesentlichen zylinderförmig mit einer Mittenlängsachse (M) ausgebildet ist und wobei der Einkristall ein äußeres Merkmal (4) aufweist, dessen Orientierung zu einer bestimmten kristallographischen Richtung (K) des Einkristalls bekannt ist, in eine Mehrzahl von Abschnitten (20a bis 20e) vorbestimmter Dicke senkrecht zur Mittenlängsachse,
Verbinden der Abschnitte derart, daß das äußere Merkmal eines jeden Abschnittes eine unterschiedliche azimutale Position zur Mittenlängsachse einnehmen,
gleichzeitiges Trennen des derart zusammengesetzten Einkristalls (20) in einer Trennvorrichtung in Scheiben mit der Dicke eines später herzustellenden Wafers,
Messen der Oberflächenebenheit und/oder Dicke der derart erzeugten Scheiben,
Ermitteln des optimalen Winkels (ρ) der bestimmten kristallographischen Richtung (K) relativ zu einer Vorschubrichtung (V) eines Trennwerkzeugs.

17. Testverfahren nach Anspruch 16, **dadurch gekennzeichnet, daß** das äußere Merkmal ein Flat oder ein Notch ist.

## Claims

1. A method for cutting single-crystal materials, in which a single crystal (1) to be cut into at least two parts and a cutting tool (2, 3; 8, 8a, 8b, 8c) are moved relative to one another in a direction of feed (V), and in which the single crystal (1) is oriented such that a particular crystallographic direction (K) lies in the plane (T) of cutting, **characterised in that** an angle (ρ) between the particular crystallographic direction (K) and the direction of feed (V) is selected such that forces which during cutting act on the cutting tool in a direction perpendicular to the plane (T) of cutting compensate one another or add up to a predetermined force.

2. A method according to Claim 1, **characterised in that** a deflection (X) of the cutting tool (2, 3; 8, 8a, 8b, 8c) is measured during cutting and the single crystal (1) is rotated as a function of the measured value with respect to the particular crystallographic direction (K) in the plane (T) of cutting.

3. A method according to Claim 1 or 2, **characterised in that** the cutting is performed by means of inner diameter sawing.

4. A method according to Claim 1 or 2, **characterised in that** the cutting is performed by means of wire sawing.

5. A method according to one of Claims 1 to 4, **characterised in that** the angle (p) is determined empirically before cutting.

6. A method according to one of Claims 1 to 5, **characterised in that** the angle (ρ is adjusted by way of an adjustment device outside the actual cutting device.

7. A method according to one of Claims 1 to 6, **characterised in that** the method is used to cut single crystals (1) of III-V semiconductors, in particular GaAs.

8. A device for cutting single crystals, having a cutting tool (2, 3; 8, 8a, 8b, 8c), a holder for the single crystal (1), a drive for moving the holder and the cutting tool relative to one another in a direction of feed (V) which extends perpendicular to the centre longitudinal axis (M) of the single crystal (1), and a rotation device (5) for rotating the holder, by means of which the holder is rotatable such that the single crystal (1) can be rotated about its centre longitudinal axis (M), **characterised by** a measuring device (6) for measuring a deflection (X) of the cutting tool in a direction perpendicular to the direction of feed (V).

9. A device according to Claim 8, **characterised by** a regulating device which is connected to the measuring device (6) and the rotation device (5) and which controls the rotation device (5) such that the single crystal is rotated such that the deflection of the cutting tool substantially reaches 0 or a predetermined value.

10. A device according to Claim 8 or 9, **characterised in that** the device is an inner diameter sawing device.

11. A device according to Claim 8 or 9, **characterised in that** the device is a wire sawing device.

12. A device for adjusting a single crystal, in which the single crystal (1) is constructed to be substantially cylindrical and has a centre longitudinal axis (M), and in which the single crystal has a planar outer face portion (4), and a particular crystallographic direction (K) of the single crystal is at a known angle (α) to the normal (N) on the planar outer face portion in a plane perpendicular to the centre longitudinal axis (M), having a stop which is provided on a vertically aligned support (51) and has a lower edge (54) which forms a predetermined angle (γ) with the vertical.

13. A device according to Claim 12, **characterised in that** the stop is adjustable in height.

14. A device according to Claim 12 or 13, **characterised in that** different exchangeable stops having different angles (γ) are provided.

15. A device according to one of Claims 12 to 14, **characterised in that** the device is an adjustment device for carrying out the method according to one of Claims 1 to 8.

16. A test method for determining the optimum angle between the particular crystallographic direction (K) and the direction of feed (V) of the method according to one of Claims 1o to 8, having the steps of
cutting a single crystal, in which the single crystal is constructed to be substantially cylindrical and has a centre longitudinal axis (M), and in which the single crystal has an external feature (4) whereof the orientation with respect to a particular crystallographic direction (K) of the single crystal is known, into a plurality of portions (20a to 20e) of predetermined thickness perpendicular to the centre longitudinal axis, connecting the portions such that the external feature of each portion adopts a different azimuthal position with respect to the centre longitudinal axis (M),
in a cutting device, simultaneously cutting the single crystal (20) composed in this way into slices having the thickness of a wafer to be made later,
measuring the surface planarity and/or thickness of the slices thus produced, determining the optimum angle (p) of the particular crystallographic direction (K) in relation to a direction of feed (V) of a cutting tool.

17. A test method according to Claim 16, **characterised in that** the external feature is a flat or a notch.

## Revendications

1. Procédé pour la découpe de matériaux monocristallins dans lequel un monocristal (1) à découper en au moins deux parties et un outil de coupe (2, 3 ; 8, 8a, 8b, 8c) sont déplacés l'un par rapport à l'autre dans une direction d'avancement (V) et dans lequel le monocristal (1) est orienté de telle manière qu'une orientation cristallographique déterminée (K) se trouve dans le plan de coupe (T), **caractérisé en ce qu'**un angle (ρ) entre l'orientation cristallographique déterminée (K) et la direction d'avancement (V) est choisi de telle sorte que les forces agissant perpendiculairement au plan de coupe (T) sur l'outil de coupe pendant la coupe se compensent ou s'additionnent pour donner une force prédéterminée.

2. Procédé selon la revendication 1, **caractérisé en ce qu'**une déviation (X) de l'outil de coupe (2, 3 ; 8, 8a, 8b, 8c) pendant la coupe est mesurée et le monocristal (1) est tourné en fonction de la valeur mesurée avec l'orientation cristallographique déterminée (K) dans le plan de coupe (T).

3. Procédé selon la revendication 1 ou 2, **caractérisé en ce que** la coupe est réalisée par sciage par trou intérieur.

4. Procédé selon la revendication 1 ou 2, **caractérisé en ce que** la coupe est réalisée par sciage au fil.

5. Procédé selon l'une des revendications 1 à 4, **caractérisé en ce que** l'angle (ρ) est déterminé empiriquement avant la coupe.

6. Procédé selon l'une des revendications 1 à 5, **caractérisé en ce que** le réglage de l'angle (ρ) est réalisé par un dispositif d'ajustement à l'extérieur du dispositif de coupe proprement dit.

7. Procédé selon la revendication 1 à 6, **caractérisé en ce que** le procédé est utilisé pour la découpe de monocristaux (1) de semiconducteurs III-V, en particulier de GaAs.

8. Dispositif pour la découpe de monocristaux avec un outil de coupe (2, 3 ; 8, 8a, 8b, 8c), une fixation pour le monocristal (1), un mécanisme d'entraînement destiné à déplacer la fixation et l'outil de coupe l'un par rapport à l'autre dans une direction d'avancement (V) perpendiculaire à l'axe longitudinal médian (M) du monocristal (1), et un dispositif tournant (5) destiné à faire tourner la fixation, qui peut faire tourner la fixation de telle sorte que le monocristal (1) puisse être tourné autour de son axe longitudinal médian (M), **caractérisé en ce qu'**il comporte un dispositif de mesure (6) pour la mesure d'une déviation (X) de l'outil de coupe dans un sens perpendiculaire à la direction d'avancement (V).

9. Dispositif selon la revendication 8, **caractérisé en ce qu'**il comporte un dispositif de régulation relié au dispositif de mesure (6) et au dispositif tournant (5) et qui commande le dispositif tournant (5) de telle manière que le monocristal soit tourné de sorte que la déviation de l'outil de coupe soit sensiblement égale à zéro ou atteigne une valeur prédéterminée.

10. Dispositif selon la revendication 8 ou 9, **caractérisé en ce que** le dispositif est un dispositif de sciage par trou intérieur.

11. Dispositif selon la revendication 8 ou 9, **caractérisé en ce que** le dispositif est un dispositif de sciage à fil.

12. Dispositif pour l'ajustement d'un monocristal, lequel monocristal (1) est sensiblement cylindrique avec un axe longitudinal médian (M), dans lequel le monocristal présente une partie de surface extérieure plane (4) et une orientation cristallographique déterminée (K) du monocristal forme un angle (α) connu par rapport à la normale (N) à la partie de surface extérieure plane dans un plan perpendiculaire à l'axe longitudinal médian (M), avec une butée prévue sur un support (51) orienté verticalement et ayant un bord inférieur (54) qui forme avec la verticale un angle (γ) prédéterminé.

13. Dispositif selon la revendication 12, **caractérisé en ce que** la butée est réglable en hauteur.

14. Dispositif selon la revendication 12 ou 13, **caractérisé en ce qu'**il est prévu différentes butées amovibles ayant des angles (γ) différents.

15. Dispositif selon l'une ou l'ensemble des revendications 12 à 14, **caractérisé en ce que** le dispositif est un dispositif d'ajustement pour la mise en oeuvre du procédé selon l'une des revendications 1 à 8.

16. Procédé de test pour la détermination de l'angle optimal entre l'orientation cristallographique déterminée (K) et la direction d'avancement (V) dans le procédé selon l'une des revendications 1 à 8, comprenant les étapes de :
- découpe d'un monocristal, lequel monocristal est sensiblement cylindrique avec un axe longitudinal médian (M) et présente une caractéristique externe (4) dont l'orientation par rapport à une orientation cristallographique déterminée (K) du monocristal est connue, en une pluralité de tronçons (20a à 20e) d'épaisseur prédéterminée perpendiculairement à l'axe longitudinal médian,
- assemblage des tronçons de telle manière que la caractéristique externe de chaque tronçon prenne une position azimutale différente par rapport à l'axe longitudinal médian,
- découpe simultanée du monocristal (20) ainsi assemblé en disques ayant l'épaisseur d'une plaquette qui sera ultérieurement fabriquée, dans un dispositif de coupe,
- mesure de la planéité de surface et/ou de l'épaisseur des disques ainsi obtenus,
- détermination de l'angle (ρ) optimal de l'orientation cristallographique déterminée (K) par rapport à une direction d'avancement (V) d'un outil de coupe.

17. Procédé de test selon la revendication 16, **caractérisé en ce que** la caractéristique externe est un méplat ou une encoche.
